# EUROPEAN PATENT SPECIFICATION

(11) **EP 0 880 144 B1**
(45) Date of publication and mention of the grant of the patent: **23.02.2005**
(21) Application number: 98304119.5
(22) Date of filing: 26.05.1998
(51) Int. Cl.: G11C 17/12, G11C 7/00

(54) **Read only memory**
Festwertspeicher
Mémoire morte

(30) Priority: 24.05.1997 KR 9720507
(43) Date of publication of application: 25.11.1998
(73) Proprietor: Samsung Electronics Co., Ltd., Suwon City, Kyungki-do (KR)
(72) Inventor: Choi, Byung-Sun, Paldal-ku, Suwon, Kyunggi-do (KR)
(74) Representative: Boakes, Jason Carrington

(56) References cited:
- EP-A- 0 580 467
- JP-A- 9 331 030
- US-A- 5 268 861
- US-A- 5 349 563
- US-A- 5 621 697

## Description

The invention relates to read only memories (ROMs), and more specifically to NOR-type ROMs.

A commonly used ROM (or mask ROM), is the NOR-type ROM having sources and drains of memory cells formed with N-type conductive regions, such as diffusion regions, and word lines arranged perpendicular to the N-type conductive regions. A circuit pattern with a matrix of memory cells in N-type conductive layers has been proposed in U.S. Pat. No. 5,268,861 by Y. Hotta et al and U.S. Pat. No. 5,349,563 by T. Iwase.

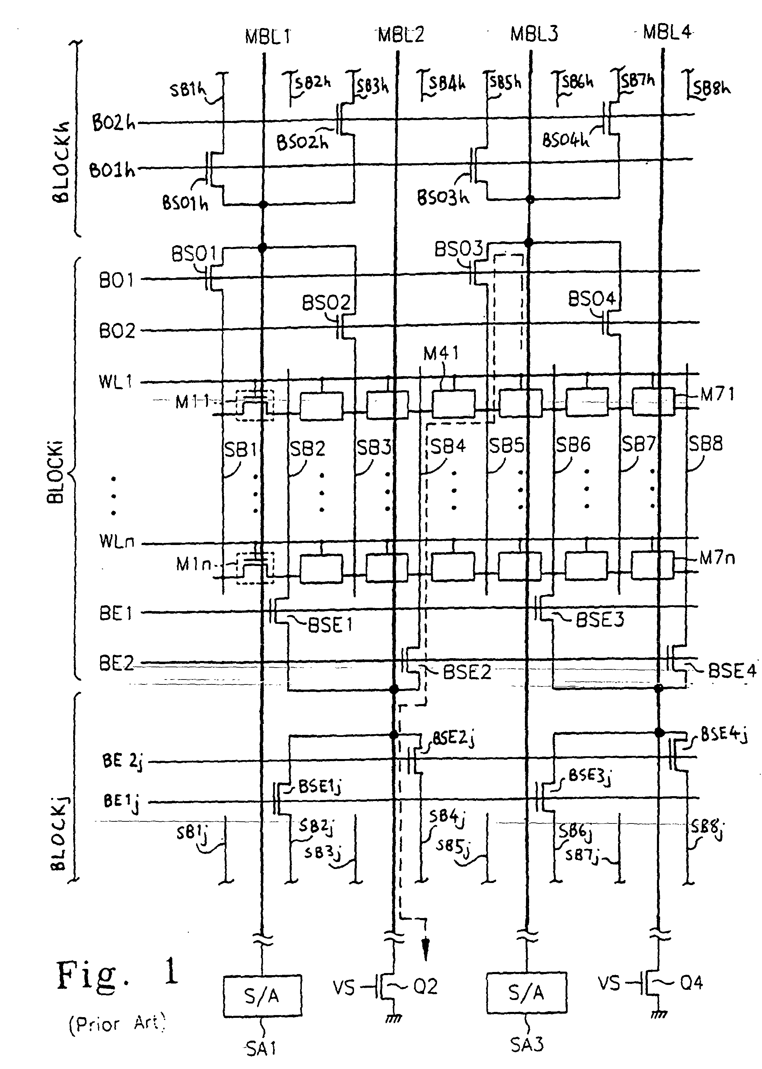

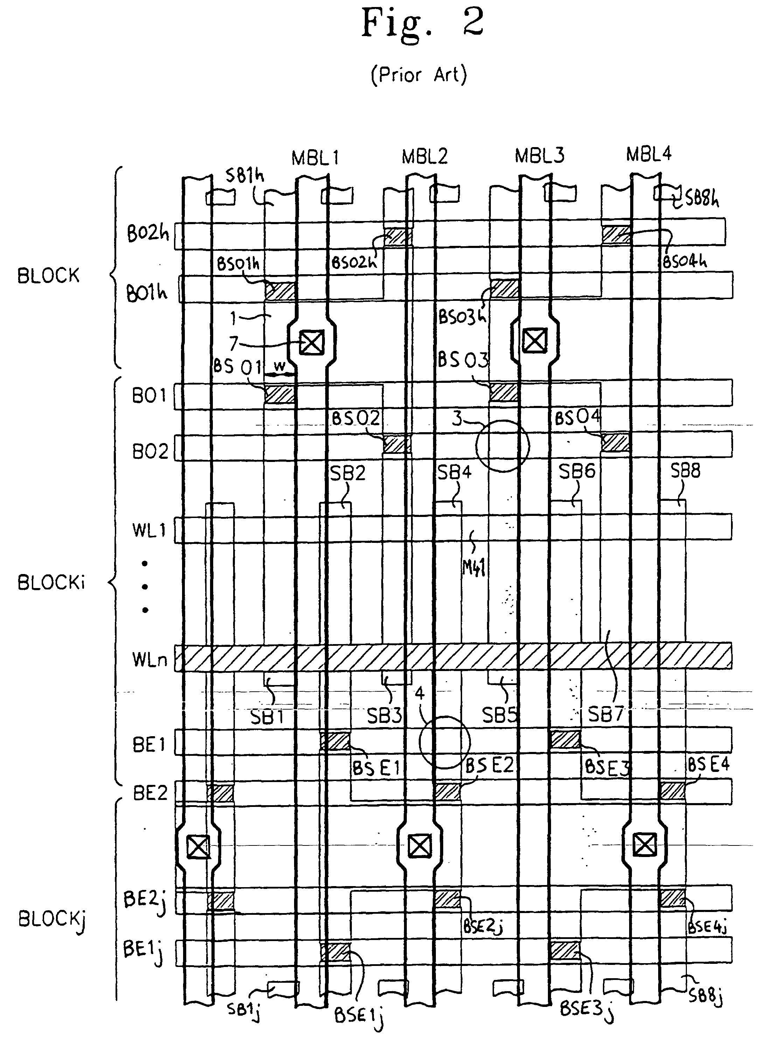

Figure 1 shows the Hotta circuit configuration of a ROM memory cell array, having memory cells M11 to M7n in each of several blocks h, i, j. Figure 2 shows a layout of the same memory cell array. The following description particularly refers to block i shown in the figures, with corresponding features on other blocks being identified by an appropriate suffix h, j.

In Figure 1, the bitlines include main bitlines MBL1-MBL4 and sub-bitlines SB1-SB8. Each of the odd-numbered main bitlines is connected to two odd-numbered sub-bitlines through respective odd bank selection transistors BSO1-BSO4. Gates of BSO1 and BSO3 are coupled to a first odd bank selection line BO1 and gates of BSO2 and BSO4 to a second odd bank selection line B02.

Each of the even-numbered main bitlines are connected to two even-numbered sub-bitlines through respective even bank selection transistors BSE1-BSE4 in which gates of BSE1 and BSE3 are coupled to first even bank selection line BE1 and gates of BSE2 and BSE4 to second even bank selection line BE2.

The odd-numbered main bitlines MBL1 and MBL3 are respectively coupled to sense amplifiers SA1 and SA3. The even-numbered main bitlines MBL2 and MBL4 are each connected to a ground potential through respective transistors Q2 and Q4, gates of which are connected to a control signal VS.

Each of word lines WL1-WLn intersecting the bitlines is coupled to control gates of a corresponding row of memory cells, while each of the sub-bitlines is coupled to pairs of adjacent memory cells, in columns.

In the following description, it is assumed that each of the various transistors referred to is rendered conductive by the application of a high potential to their control gate.

During a read operation, assuming that M41 is the cell to be selected and read, BO1 and BE2 are set into a high potential while BO2 and BE1 are held in a low potential. Wordline WL1 goes to high level and VS is high, rendering Q2 conductive. Therefore, the current path for sensing is formed from sense amplifier SA3 to the ground, through MBL3, BSO3, SB5, M41, SB4, BSE2, MBL2 and Q2.

Referring to Figure 2, sub-bitlines SB1-SB8 are formed of an N-type conductive layer, such as a diffusion layer, which is also used to form active regions of the bank selection transistors BSO, BSE. The width of the sub-bitlines therefore determines the channel width W of the bank selection transistors as shown. The width W of the bank selection transistors is thus limited, leading to a relatively high on-resistance (a resistance experienced by the sensing current flowing through a conductive cell when read). Such resistance reduces the amount of the sensing current available for reading the cell.

It is common that the current path for sensing includes two regions 3 and 4 which are vertically formed of a diffusion layer forming a sub-bitline, a gate oxide layer and a wordline (in this case, a bank selection line). Such structures introduce unwanted capacitance in the sensing current path, cause the level of the sensing voltage to be reduced, and degrade the efficiency of sensing.

Furthermore, each main bitline is connected to the active region of the corresponding bank selection transistor, at region 1 of the N-type conductive layer, through contact 7 (shown in Figure 2 in respect of main bitline MBL1 only). With this construction, a junction capacitance between the main bitline and the region 1 and a gate capacitance of the bank selection transistor BSO1 at each sub bitline SB1 adversely influences the speed of data access.

EP 580 467 discloses a memory device having a plurality of memory blocks, with block selection parts disposed between adjacent memory blocks.

Document US 5,621,697, on which the preamble of the independent claims is based, discloses a memory device comprising memory block and block selection transistors.

It is an aim of the invention to provide a ROM capable of enhancing data access speed.

It is another aim of the invention to provide a ROM with reduced resistance and capacitance during read operations.

According to a first aspect of the present invention there is provided a memory device comprising a plurality of memory blocks each containing a plurality of memory cells and being associated with main bitlines and sub-bitlines; wherein
the memory device comprises a block selection part disposed between adjacent blocks;
at least a first subset of the sub-bitlines extend between at least two adjacent blocks;
the first subset of the sub-bitlines is selectively connectable to corresponding ones of the main bitlines through the block selection part;
the block selection part contains a plurality of block selection transistors which are adapted to selectively connect the sub-bitlines to corresponding ones of the main bitlines; and
the block selection part includes a plurality of conductive block selection lines; characterised in that
the block selection transistors have a channel width determined by a width of a corresponding block selection line and a channel blocking region is interposed under each block selection line to prevent an unwanted connection.

Preferably, the block selection part is commonly used by the adjacent blocks.

The memory device preferably further comprises sense amplifiers for reading information stored in the memory cells, through the main bitlines.

The memory device of the invention preferably further comprises a substrate upon which the plurality of memory blocks are defined; and a plurality of conductive layers formed in the substrate, extending in a column direction to adjacent blocks, for use as the sub-bitlines.

The block selection lines are preferably arranged in a row direction and formed over the conductive layers in an inter-sectional pattern, the block selection lines being connected to control terminals of the block selection transistors formed in the block selection part; and a plurality of conductive main bitlines are formed over the block selection lines.

In an embodiment of the invention, the memory device further comprises a plurality of conductive second block selection lines arranged in the row direction and formed over the conductive layers in an intersectional pattern. The second block selection lines are connected to second block selection transistors formed in a second selection part shared by adjacent blocks. A plurality of conductive main bitlines are formed over the second block selection lines and are selectively connectable to a second subset of the sub-bitlines through the second block selection transistors.

Preferably, the block selection transistors and/or the second block selection transistors are formed in a conductive region of the substrate and are defined by field oxide regions.

Preferably, one of the conductive layers is electrically disconnected from another conductive layer by a channel blocking region.

In an embodiment of the invention, the block selection transistor is arranged in series with an associated depletion transistor, which is rendered conductive during a read operation.

According to a second aspect of the present invention there is provided a method of reading a selected memory cell in a memory block of a memory device, the memory block being situated between first and second adjacent blocks, the method comprising the steps of:
activating a first switching device to connect a first main bitline to a first sub-bitline adjacent to the selected memory cell; and
activating a second switching device to connect a second main bitline to a second sub-bitline adjacent to the selected memory cell; wherein
the connecting of at least one of first and second sub-bitlines causes connection of a corresponding sub-bitline in one of first and
second adjacent blocks, to the corresponding main bitline; characterised in that
the connecting of at least one of first and second sub-bitlines is provided by means of a block selection transistor having a channel width determined by the width of a corresponding block selection line; and a channel blocking region is interposed under each block selection line to prevent an unwanted connection.

Certain embodiments of the invention will now be described, by way of examples only, with reference to the accompanying drawings, in which:
Figure 1 shows a circuit diagram of a conventional cell array in a NOR-type ROM;
Figure 2 shows a layout corresponding to the circuit of Figure 1;
Figure 3 shows a circuit diagram of a proposed cell array in a ROM according to a first embodiment of the invention;
Figure 4 shows a layout corresponding to the circuit of Figure 3;
Figure 5 shows a circuit diagram of a proposed cell array in a ROM according to a second embodiment of the invention; and 6
Figure 6- shows a layout corresponding to the circuit of Figure 5.

In the figures, like reference numerals denote like or corresponding parts, with appropriate suffixes indicating features in various blocks. The suffix * denotes subsidiary references.

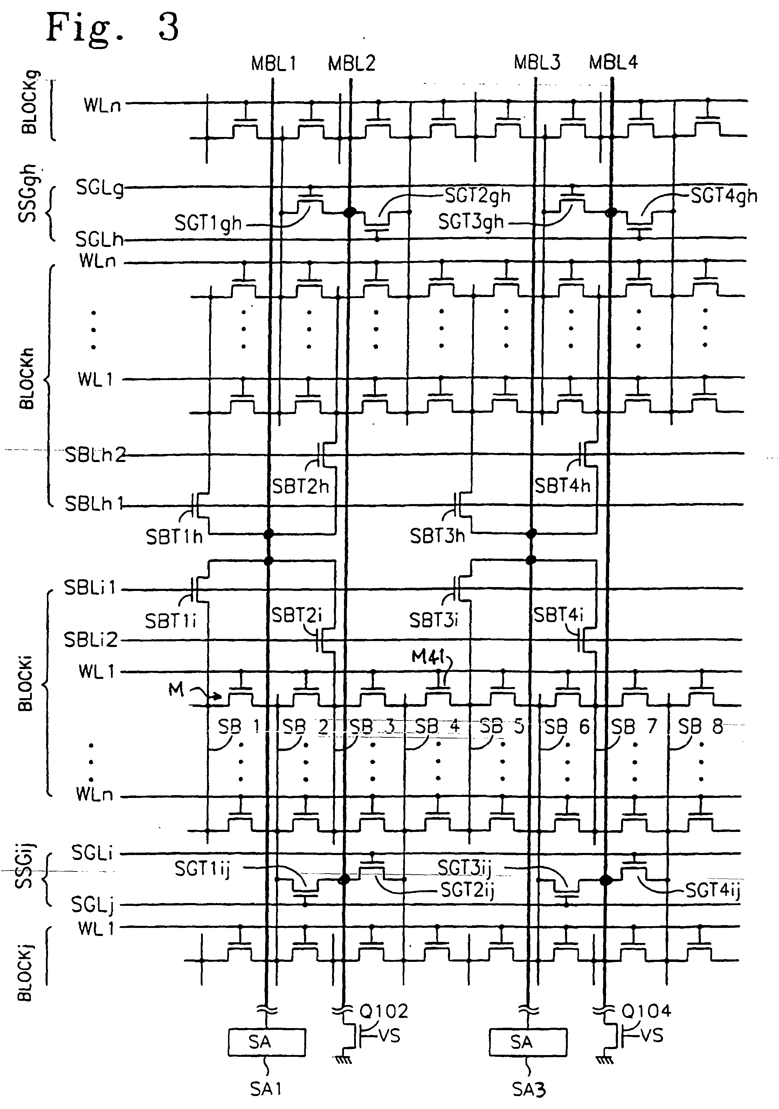

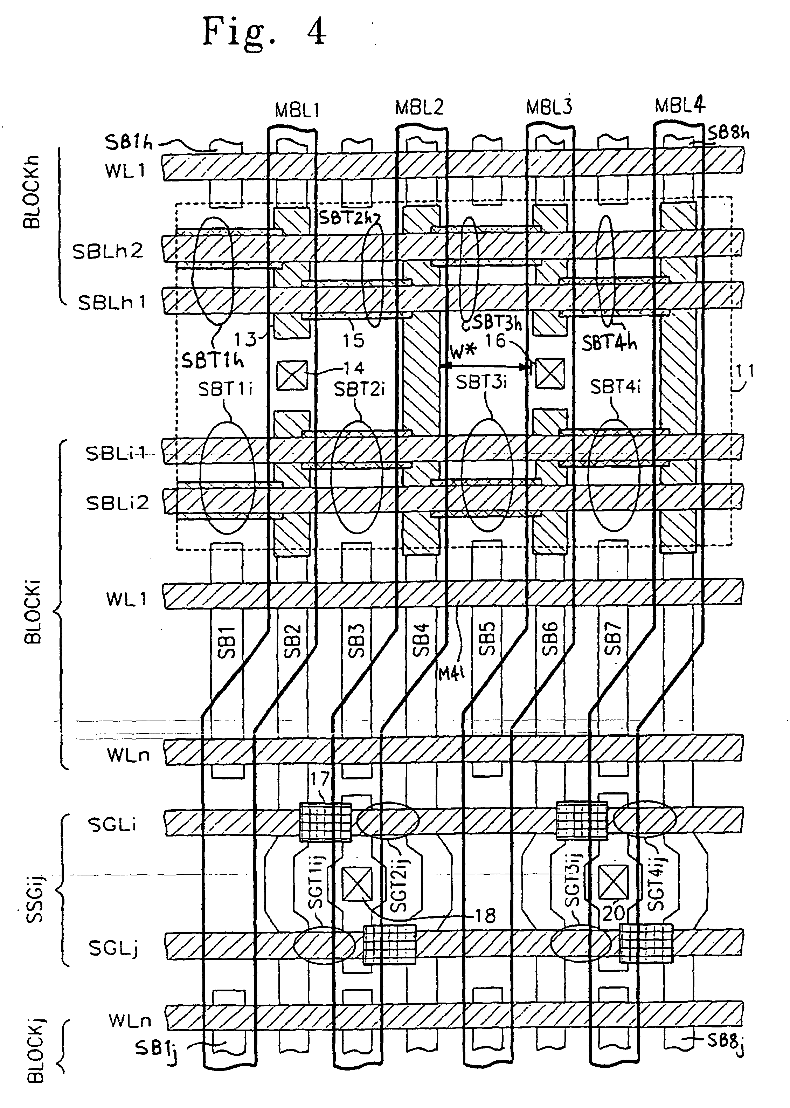

Figures 3 and 4 illustrate a first embodiment of the invention. Referring to Figure 3, blocks BLOCKg, BLOCKh, BLOCKi and BLOCKj are adjacently arranged in the direction of the length of the bitlines, that is, the column direction.

Main bitlines MBL1-MBL4 are arranged over the blocks, parallel with sub-bitlines SB1-SB8. The main bitlines and the associated sub-bitlines are connected through block selection transistors SBT* for odd main bitlines and ground selection transistors SGT* for even main bitlines. In the blocks, each of the odd-numbered main bitlines MBL1 and MBL3 (referred to as virtual bitlines) are connected to two adjacent odd-numbered sub-bitlines, SB1, SB3 and SB5, SB7 through corresponding block selection transistors SBT*. Each of the even-numbered main bitlines MBL2 and MBL4 (referred to as virtual ground lines) are connected to two adjacent even-numbered sub-bitlines SB2, SB4; SB6, SB8 through two of the ground selection transistors SGT*. The virtual bitlines MBL1 and MBL3 are connected to sense amplifiers SA1 and SA3, respectively, while the virtual ground lines MBL2 and MBL4 are connected to ground through corresponding transistors Q102 and Q104 whose gates are coupled to control signal VS. In each of the blocks g, h, i, j, each of word lines WL1-WLn intersect the bitlines and is coupled to control gates of a row of memory cells M. Each of the sub-bitlines SB1-SB8 is coupled to pairs of adjacent memory cells, in columns.

It should be noted that at least some of the sub-bitlines are shared by the adjacent blocks. In this example, the even-numbered sub-bitlines of BLOCKi are shared with the adjacent block BLOCKj and the even-numbered sub-bitlines of BLOCKh are shared with BLOCKg. A block selecting part SSGgh; SSGij for selectively connecting each of blocks to the virtual ground lines MBL2, MBL4 are interposed between adjacent blocks, at an interval of two blocks, for sharing the shared sub-bitlines between the adjacent blocks. In this case, the even numbered sub-bitlines are shared, being the ground selecting field. SSGgh lies between BLOCKg and BLOCKh; SSGij lies between BLOCKi and BLOCKj.

In SSGgh, block selection line SGLg is coupled to gates of selection transistors SGT1gh and SGT3gh which are respectively connected to the virtual ground lines MBL2 and MBL4, and block selection line SGLh is coupled to gates of selection transistors SGT2gh and SGT4gh which are respectively connected to MBL2 and MBL4.

In SSGij, block selection line SGLi is coupled to gates of selection transistors SGT2ij and SGT4ij which are respectively connected to the virtual ground lines MBL2 and MBL4, and block selection line SGLj is coupled to gates of selection transistors SGT1ij and SGT3ij which are respectively connected to MBL2 and MBL4.

Each block has its own selecting part SBT*, SBL* to connect unshared sub-bitlines (in this example, the odd numbered sub-bitlines, being the bitline selecting field) to the virtual bitlines MBL1, MBL3 in response to selection lines SBLi1, SBLi2, SBLh1 and SBLh2.

In respect of the selection parts of the bitline selecting field contained with each block, in BLOCKi, selection signal SBLi1 is coupled to gates of selection transistors SBT1i and SBT3i which are respectively connected to the virtual bitlines MBL1 and MBL3, and selection signal SBLi2 is coupled to selection transistors SBT2i and SBT4i which are respectively connected to MBL1 and MBL3. Similarly, in BLOCKh, selection signal SBLh1 is coupled to gates of selection transistors SBT1h and SBT3h which are respectively connected to the virtual bitlines MBL1 and MBL3, and selection signal SBLh2 is coupled to selection transistors SBT2h and SBT4h which are respectively connected to MBL1 and MBL3. The described arrangements in the selection circuit areas may be repeated in the other adjacent blocks.

Considering a read operation of the memory cell M41 in BLOCKi, SBLi1 and SGLi go to high levels and SBLi2 and SGLj to low levels. The current path for sensing is formed from the sense amplifier SA3, through virtual bitline MBL3 to ground, via selection transistor SBT3i, sub-bitline SB5, the selected memory cell M41, sub-bitline SB4, selection transistor SGT2ij, the virtual ground line MBL2 and transistor Q102.

Referring to Figure 4, the selection transistors SBT* are constructed on N+ conductive layer 11, such as a diffusion layer. Each selection transistor SBT* includes an associated depletion transistor with a doped (e.g. diffused) channel region 15 formed at the position over which a bank selection line SBL* other than the bank selection line controlling the transistor in question, passes.

Contacts 14 and 16 are provided to connect MBL1 to SBT1i (or SBT1h) and SBT2i (or SBT2h), and MBL3 to SBT3i (or SBT3h) and SBT4i (or SBT4h) , respectively. Field oxide regions 13 isolate the active regions (being parts of N+ conductive layer 11) of the block selection transistors SBT* from each other. Thus, the pairs of SBT1i(h) and SBT2i (h), and of SBT3i(h) and SBT4i(h) each share drain active regions which are contacted to MBL1 and MBL3 respectively. The conductive (e.g. diffused) layers forming the odd-numbered sub-bitlines, which in this example are not shared with an adjacent block, are conductively connected to N+ conductive layer 11.

Considering SSGij, contacts 18, 20 are provided to connect MBL2, MBL4 to associated conductive (e.g. diffused) regions. The associated conductive regions are interposed between adjacent odd, or even, sub-bitlines. The contacts connect to the centre of the associated conductive regions, which extend within each block selection part SSG* parallel to the sub-bitlines to a length sufficient to pass under a selection line in each direction, Over their length, the associated conductive regions replace a length of a corresponding even or odd sub-bitline. Block selection lines SGL* pass in an intersectional pattern over these associated conductive regions and sub-bitlines, formed of conductive layers. Where a block selection line SGL* passes over an interval between a sub-bitline and a conductive region associated with a virtual ground line MBL2, MBL4, a selection transistor SGT* is formed.

To prevent connection of a virtual ground line to both adjacent even numbered sub-bitlines when a block selection line SGL* is activated, a channel blocking region 17 having a threshold voltage higher than a power supply voltage is interposed under each selection line SGL* to prevent unwanted connections. As four possible ground selection transistors SGT* are provided: one at either side of the virtual ground line, in respect of each selection line SGL*, two possible transistors must be disabled. The transistors disabled by the addition of channel blocking region 17 are diagonally opposite ones. The remaining, active, transistors SGT1ij, SGT2ij are arranged as one per sub-bitline and per selection line SGL*. The regions 17 can be formed by an implantation process after patterning the sub-bitlines.

Each of the selection transistors SBT, as shown in Figure 4, has channel width W* extending between field oxide regions 13. This width W* is wider than the bank selection transistor in Figures 1 and 2, and is not limited by a width of the conductive layer of the corresponding sub-bitline SB5. Advantageously, the channel width W* may be about three times that of the conductive layer of the sub-bitline.

The staggered and shared arrangement with the ground selection transistors SGT* and sub-bitlines SB* makes the current path for sensing be more direct, and less resistive, because, for instance, the current path for reading the memory cell M41 includes three transistor regions, that is, SBT3i, the channel region of the depletion transistor which is serially connected to SBT3i and has a control gate of SBLi2, and SGT2ij (see the four transistor regions for the equivalent sensing path in Figures 1 and 2). Further, the common use of half of the sub-bitlines between adjacent blocks reduces surface area required in the cell array region of the memory device.

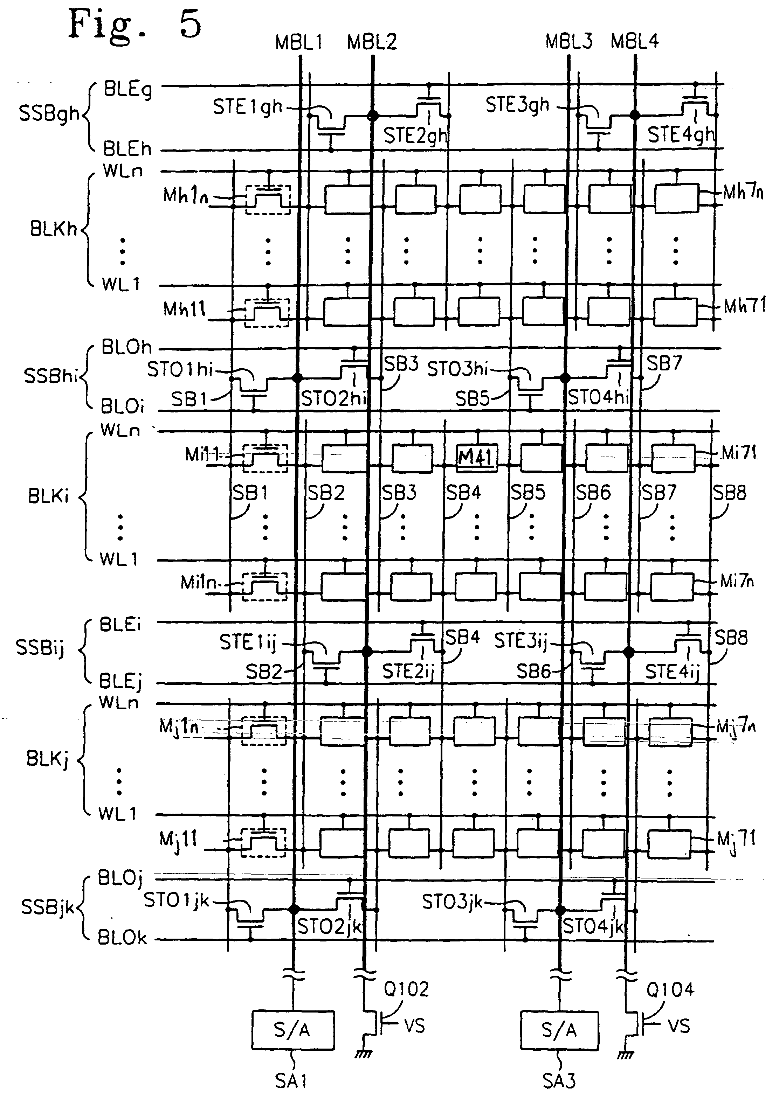

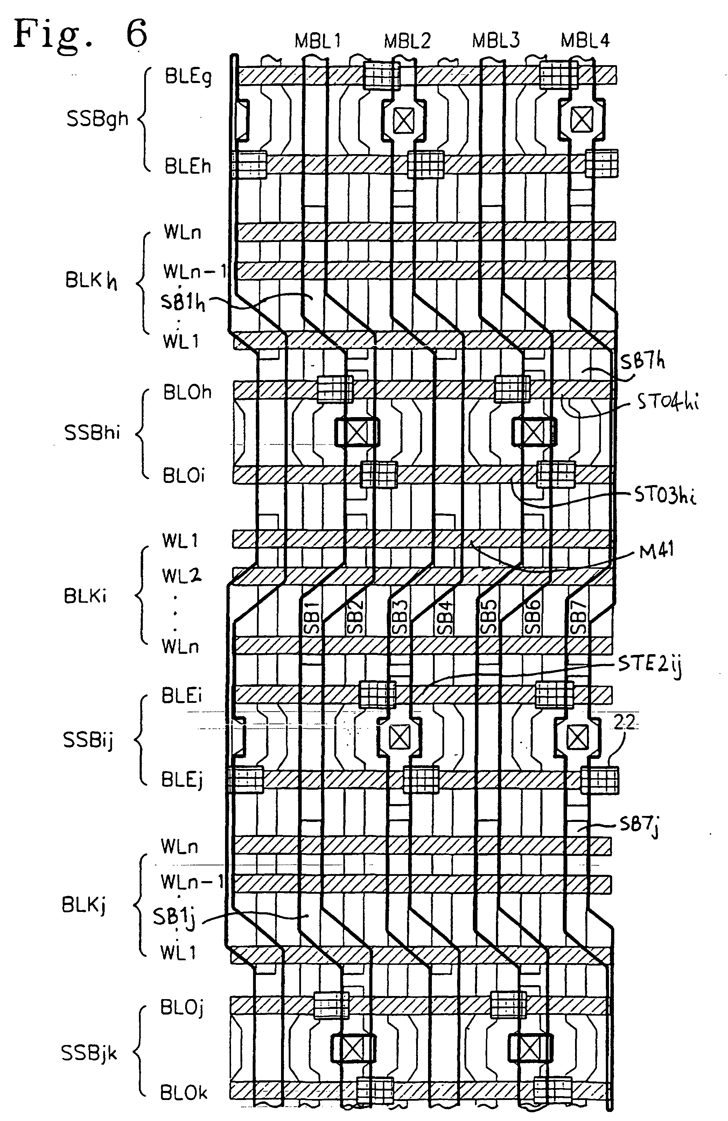

Figures 5 and 6 show a second embodiment of the invention. In particular, this second embodiment provides sharing of all of the selection transistors and sub-bitlines between adjacent blocks.

Referring to Figure 5, a memory circuit according to the second embodiment of the invention includes the odd- and even-numbered main bitlines, MBL1 and MBL3, and MBL2 and MBL4, referred to as virtual bitlines and virtual ground lines, and adjacent memory blocks BLKh, BLCKi and BLCKj. Main bitlines MBL1-MBL4 extend in a column direction, in parallel with sub-bitlines SB1-SB8. The main bitlines and sub-bitlines are connected through selection transistors STE* (to interconnect virtual ground lines and even-numbered sub-bitlines) and STO* (to interconnect virtual bitlines and odd-numbered sub-bitlines).

In each of the blocks, each of the virtual bitlines MBL1 and MBL3 is connected to two adjacent odd-numbered sub-bitlines, SB1, SB3; and SB5, SB7 through two block selection transistors STO*. Each of the virtual ground lines MBL2 and MBL4 is connected to two adjacent even-numbered sub-bitlines, SB2, SB4; and SB6, SB8 through two ground selection transistors STE*. MBL1 and MBL3 are connected to sense amplifiers SA1 and SA3, respectively, while MBL2 and MBL4 are connected to ground through corresponding transistors Q102 and Q104 whose gates are coupled to control signal VS. In each of the blocks, each of word lines WL1-WLn intersecting the bitlines is coupled to control gates of a row of memory cells, while each of the sub-bitlines is coupled to pairs of adjacent memory cells arranged in columns.

This second embodiment differs from the first embodiment (shown in Figure 3) at least in that all of the sub-bitlines in a block are shared with adjacent blocks. In this example, the odd-numbered sub-bitlines of BLKi are shared with BLKh and the even-numbered sub-bitlines of BLKi are shared with BLKj. Block selection parts SSBgh, SSBhi, SSBij and SSBjk, for connecting each of blocks to the virtual bit and ground lines, are interposed between adjacent blocks at an interval of one block, for selectively activating the shared sub-bitlines. SSBgh lies between BLKg and BLKh; SSBhi lies between BLKh and BLKi; SSGij lies between BLKi and BLKj.

In SSBgh, block selection line BLEg is coupled to gates of selection transistors STE2gh and STE4gh which are respectively connected to MBL2 and MBL4, and block selection line BLEh is coupled to gates of selection transistors STE1gh and STE3gh which are also respectively connected to MBL2 and MBL4. In SSBhi, block selection line BLOh is coupled to gates of selection transistors STO2hi and STO4hi which are respectively connected to MBL1 and MBL3, and block selection line BLOi is coupled to gates of selection transistors STO1hi and STO3hi which are also respectively connected to MBL1 and MBL3. In SSBij, block selection line BLEi is coupled to gates of selection transistors STE2ij and STE4ij which are respectively connected to MBL2 and MBL4, and block selection line BLEj is coupled to gates of selection transistors STE1ij and STE3ij which are respectively connected to MBL2 and MBL4. In SSBjk, block selection line BLOj is coupled to gates of selection transistors STO2jk and STO4jk which are respectively connected to MBL1 and MBL3, and block selection line BLOk is coupled to gates of selection transistors STOljk and STO3jk which are also respectively connected to MBL1 and MBL3. In the circuit arrangement, the selection transistors STO* are used for connecting a virtual bitline to an adjacent odd-numbered sub-bitline while the selection transistors STE* are used for connecting a virtual ground line to an adjacent even-numbered sub-bitline.

When the memory cell M41 of BLKi is selected for reading, BLOi and BLEi to go high levels while BLOh and BLEj to low levels. At this time, the control signal VS is high level to turn Q102 on. The current path for sensing is formed from the sense amp SA3, through the virtual bitline MBL3 to the ground, via selection transistor STO3hi, sub-bitline SB5, the selected memory cell M41, sub-bitline SB4, selection transistor STE2ij, the virtual ground line MBL2 and transistor Q102.

The layout of Figure 6 corresponds to the circuit of Figure 5. Similarly to the layout shown in shared ground selection parts of Figure 4, contacts are provided to connect main bitlines MBL* to associated conductive (e.g. diffused) regions. The associated conductive regions are interposed between adjacent odd, or even, sub-bitlines. The contacts connect to the centre of the associated conductive regions, which extend within each block selection part SSB* parallel to the sub-bitlines to a length sufficient to pass under a selection line in each direction. Over their length, the associated conductive regions replace a length of a corresponding even or odd sub-bitline.

Considering SSBhi, contacts are provided to connect MBL1, MBL3 to associated conductive (e.g. diffused) regions. Block selection lines BLO* pass in an intersectional pattern over these associated conductive regions and sub-bitlines, formed of conductive layers. Where a block selection line BLO* passes over an interval between a sub-bitline and a conductive region associated with a virtual bitline MBL1, MBL3, a selection transistor STO* is formed.

To prevent connection of a virtual bitline to both adjacent odd numbered sub-bitlines when a block selection line BLO* is activated, a channel blocking region 22 having a threshold voltage higher than a power supply voltage is interposed under each selection line BLO* to prevent unwanted connections. As four possible ground selection transistors STO* are provided: one at either side of each virtual bitline, in respect of each selection line BLO*, two possible transistors must be disabled. The transistors disabled by the addition of channel blocking region 22 are diagonally opposite ones. The remaining, active, transistors STO3hi, STO4hi are arranged as one per sub-bitline and per selection line BLO*. The regions 22 can be formed by an implantation process after patterning the sub-bitlines.

In this second embodiment, each of the selection transistors STO*, STE* has a channel width determined by the width of a corresponding selection line BLO*, BLE*.

The staggered and shared arrangement with the selection transistors and sub-bitlines makes the current path for sensing be more simple and less resistive, because, for instance, the aforementioned current path for the memory cell M41 includes only two selection transistor regions, that is, STO3hi and STE2ij (as opposed to the four transistor regions required for the equivalent sensing path in Figures 1 and 2). The sharing of all the sub-bitlines with adjacent blocks further reduces the surface area required in the cell array region of the memory device. This second embodiment also further reduces unwanted capacitance, allowing faster read times.

Although the present invention has been described with reference to certain particular embodiments, various modifications to the device and method are possible. The transistors described may be replaced by any suitable switching element. The conductive layer 11 and the conductive layers used as sub-bitlines, and the conductive regions associated with the main bitlines may be formed by implantation or diffusion of a suitable dopant into the substrate, or by any other suitable method. The channel blocking regions 17, 22 may similarly be formed by implantation or diffusion, or otherwise; either before, after, or at some stage in between, formation of field oxide 13, sub-bitlines, main bitlines and conductive region 11. The invention may be applied to memory devices constructed of P-type transistors, and using P-type conductive layers, with appropriate modifications to the polarities of control and power supply voltages. At least some of the advantages of the invention may be derived by applying the invention to memory devices other than those formed in a semiconductor substrate. The invention could, for example, be applied to optical devices.

The device of the invention advantageously avoids inclusion of capacitive structures such as those shown as 3, 4 in figure 2.

As described with reference to the specific embodiments, the present invention provides a capability for high integration density, increased speed of reading data from a selected memory cell by reducing capacitance on the sensing path, and provides efficiency in consumption of layout surface area for designing a cell array.

## Claims

1. A memory device comprising a plurality of memory blocks (h, i, j), each containing a plurality of memory cells (M11-M7n), and being associated with main bitlines (MBL) and sub-bitlines (SB); wherein
the memory device comprises a block selection part (SSB; SSG) disposed between adjacent blocks;
at least a first subset of the sub-bitlines extend between at least two adjacent blocks;
the first subset of the sub-bitlines is selectively connectable to corresponding ones of the main bitlines through the block selection part;
the block selection part contains a plurality of block selection transistors (STO; STE; SGT) which are adapted to selectively connect the sub-bitlines to corresponding ones of the main bitlines; and
the block selection part includes a plurality of conductive block selection lines (SGL; BLE; BLO); **characterised in that**
the block selection transistors have a channel width determine by a width of a corresponding block selection line **characterised in that** a channel blocking region (17; 22) is interposed under each block selection line to prevent an unwanted connection.

2. A memory device according to claim 1 wherein a block selection part (SSBhi) is commonly used by adjacent blocks (h, i).

3. A memory device according to any of claims 1 to 2, further comprising sense amplifiers (SA) for reading information stored in the memory cells, through the main bitlines.

4. A memory device according to any preceding claim, further comprising:
a substrate upon which the plurality of memory blocks are defined; and
a plurality of conductive layers formed in the substrate, extending in a column direction to adjacent blocks, for use as the sub-bitlines (SB).

5. A memory device according to claim 4 wherein the block selection lines are arranged in a row direction and formed over the conductive layers in an inter-sectional pattern, the block selection lines being connected to control terminals of the block selection transistors (STO; SGT; STE) formed in the block selection part; and
a plurality of conductive main bitlines (MBL) are formed over the block selection lines.

6. A memory device according to claim 5 further comprising;
a plurality of conductive second block selection lines (BLO) arranged in the row direction and formed over the conductive layers in an intersectional pattern, the second block selection lines being connected to second block selection transistors (STO) formed in a second selection part (SSBhi) shared by adjacent blocks (h, i); and
a plurality of conductive main bitlines (MBL) formed over the second block selection lines and selectively connectable to a second subset of the sub-bitlines through the second block selection transistors.

7. A memory device according to any preceding claim wherein the block selection transistors (SGT; STE) and/or the second block selection transistors (STO) are formed in a conductive region and are defined by field oxide regions.

8. A memory device according to any of claims 4 to 5 wherein one -of the conductive layers is electrically disconnected from another conductive layer by a channel blocking region (17, 22).

9. A memory device according to any of claims 1 to 8 wherein a block selection transistor is arranged in series with an associated depletion transistor, which is conductive during a read operation.

10. A method of reading a selected memory cell (M41) in a memory block (i) of a memory device, the memory block being situated between first and second adjacent blocks (h, j), the method comprising the steps of:
activating a first switching device (SGTij; STE2ij) to connect a first main bitline (MBL2) to a first sub-bitline (SB4) adjacent to the selected memory cell; and
activating a second switching device (SBT3i; ST03hi) to connect a second main bitline (MBL3) to a second sub-bitline (SB5) adjacent to the selected memory cell; wherein
the connecting of at least one of first and second sub-bitlines causes connection of a corresponding sub-bitline (SB4j; SB5h) in one of first and second adjacent blocks, to the corresponding main bitline (MBL2; MBL3) **characterised in that**
the connecting of at least one of first and second sub-bitlines is provided by means of a block selection transistor (STO; STE; SGT) having a channel width determined by the width of a corresponding block selection line (SGL; BLE; BLO); **characterised in that** a channel blocking region (17; 22) is interposed under each block selection line to prevent an unwanted connection.

## Patentansprüche

1. Speichergerät, das eine Mehrzahl von Speicherblöcken (h, i, j) umfasst, die jeweils eine Mehrzahl von Speicherzellen (M11-M7n) enthalten und mit Hauptbitleitungen (MBL) und Unterbitleitungen (SB) assoziiert sind; wobei
das Speichergerät einen zwischen benachbarten Blöcken angeordneten Blockauswahlteil (SSB; SSG) umfasst;
wenigstens eine erste Teilmenge der Unterbitleitungen zwischen wenigstens zwei benachbarten Blöcken verläuft;
die erste Teilmenge der Unterbitleitungen selektiv mit entsprechenden der Hauptbitleitungen durch den Blockauswahlteil verbunden werden kann;
der Blockauswahlteil eine Mehrzahl von Blockauswahltransistoren (STO; STE; SGT) enthält, die die Aufgabe haben, die Unterbitleitungen selektiv mit entsprechenden der Hauptbitleitungen zu verbinden;
der Blockauswahlteil eine Mehrzahl von leitenden Blockauswahlleitungen (SGL; BLE; BLO) aufweist; und
die Blockauswahltransistoren eine Kanalbreite haben, die durch eine Breite einer entsprechenden Blockauswahlleitung bestimmt wird, **dadurch gekennzeichnet, dass** sich unter jeder Blockauswahlleitung eine Kanalsperrregion (17; 22) befindet, um eine unerwünschte Verbindung zu verhüten.

2. Speichergerät nach Anspruch 1, wobei ein Blockauswahlteil (SSBhi) gewöhnlich von benachbarten Blöcken (h, I) verwendet wird.

3. Speichergerät nach Anspruch 1 oder 2, das ferner Leseverstärker (SA) zum Empfangen von in den Speicherzellen gespeicherten Informationen durch die Hauptbitleitungen umfasst.

4. Speichergerät nach einem der vorherigen Ansprüche, das ferner Folgendes umfasst:
ein Substrat, auf dem die Mehrzahl von Speicherblöcken definiert ist; und
eine Mehrzahl von in dem Substrat ausgebildeten leitenden Schichten, die zur Verwendung als die Unterbitleitungen (SB) in einer Spaltenrichtung zu benachbarten Blöcken verlaufen.

5. Speichergerät nach Anspruch 4, wobei die Blockauswahlleitungen in einer Reihenrichtung angeordnet und über den leitenden Schichten in einem Schnittmuster ausgebildet sind, wobei die Blockauswahlleitungen mit Steueranschlüssen der Blockauswahltransistoren (STO; SGT; STE) verbunden sind, die in dem Blockauswahlteil ausgebildet sind; und
eine Mehrzahl von leitenden Hauptbitleitungen (MBL) über den Blockauswahlleitungen ausgebildet ist.

6. Speichergerät nach Anspruch 5, das ferner Folgendes umfasst:
eine Mehrzahl von leitenden zweiten Blockauswahlleitungen (BLO), die in der Reihenrichtung angeordnet und über den leitenden Schichten in einem Schnittmuster ausgebildet sind, wobei die zweiten Blockauswahlleitungen mit zweiten Blockauswahltransistoren (STO) verbunden sind, die in einem von benachbarten Blöcken (h,i) gemeinsam genutzten zweiten Auswahlteil (SSBhi) ausgebildet sind; und
eine Mehrzahl von leitenden Hauptbitleitungen (MBL), die über den zweiten Blockauswahlleitungen ausgebildet sind und mit einer zweiten Teilmenge der Unterbitleitungen durch die zweiten Blockauswahltransistoren selektiv verbunden werden können.

7. Speichergerät nach einem der vorherigen Ansprüche, wobei die
Blockauswahltransistoren (SGT; STE) und/oder die zweiten
Blockauswahltransistoren (STO) in einer leitenden Region ausgebildet sind und von Feldoxidregionen gebildet werden.

8. Speichergerät nach Anspruch 4 oder 5, wobei eine der leitenden Schichten von einer anderen leitenden Schicht durch eine Kanalsperrregion (17, 22) elektrisch getrennt ist.

9. Speichergerät nach einem der Ansprüche 1 bis 8, wobei ein
Blockauswahltransistor in Serie mit einem assoziierten Verarmungstransistor geschaltet ist, der während eines Lesevorgangs leitend ist.

10. Verfahren zum Lesen einer ausgewählten Speicherzelle (M41) in einem Speicherblock (i) eines Speichergerätes, wobei sich der Speicherblock zwischen dem ersten und dem zweiten benachbarten Block (h, j) befindet, wobei das Verfahren die folgenden Schritte umfasst:
Aktivieren eines ersten Schaltelementes (SGTij; STE2ij) zum Verbinden einer ersten Hauptbitleitung (MBL2) mit einer ersten Unterbitleitung (SB4) neben der gewählten Speicherzelle; und
Aktivieren eines zweiten Schaltelementes (SBT3i; ST03hi) zum Verbinden einer zweiten Hauptbitleitung (MBL3) mit einer zweiten Unterbitleitung (SB5) neben der gewählten Speicherzelle; wobei
das Verbinden der ersten und/oder zweiten Unterbitleitung eine Verbindung einer entsprechenden Unterbitleitung (SB4j; SB5h) in einem ersten oder zweiten benachbarten Block mit der entsprechenden Hauptbitleitung (MBL2; MBL3) bewirkt;
das Verbinden der ersten und/oder zweiten Unterbitleitung mittels eines Blockauswahltransistors (STO; STE; SGT) mit einer Kanalbreite erfolgt, die durch die Breite einer entsprechenden Blockauswahlleitung (SGL; BLE; BLO) bestimmt wird, **dadurch gekennzeichnet, dass** sich unter jeder Blockauswahlleitung eine Kanalsperrregion (17; 22) befindet, um eine unerwünschte Verbindung zu verhüten.

## Revendications

1. Dispositif de mémoire comprenant une pluralité de blocs de mémoire (h, i, j), chacun contenant une pluralité de cellules de mémoire (M11-M7n) et étant associé à des lignes de bits principales (MBL) et des sous-lignes de bits (SB) ; dans lequel :
le dispositif de mémoire comporte une section de sélection de blocs (SSB ; SSG) qui est disposée entre des blocs adjacents ;
au moins un premier sous-ensemble de sous-lignes de bits qui s'étend entre deux blocs adjacents au moins ;
le premier sous-ensemble de sous-lignes de bits peut être connecté de façon sélective à ceux qui lui correspondent parmi les lignes de bits principales, par l'intermédiaire de la section de sélection de blocs ;
la section de sélection de blocs contient une pluralité de transistors de sélection de blocs (STO ; STE ; SGT) lesquels sont adaptés pour connecter de façon sélective les sous-lignes de bits aux sous-lignes de bits correspondantes parmi les lignes de bits principales ; et
la section de sélection de blocs inclut une pluralité de lignes de sélection de blocs conducteurs (SGL ; BLE ; BLO) ;
les transistors de sélection de blocs ont une largeur de canal qui est déterminée par une largeur d'une ligne de sélection de blocs correspondante ; **caractérisé en ce qu'**une zone de blocage de canal (17 ; 22) est intercalée sous chaque ligne de sélection de blocs afin d'empêcher toute connexion indésirable.

2. Dispositif de mémoire, selon la revendication 1, dans lequel une section de sélection de blocs (SSBhi) est utilisée de façon commune par des blocs adjacents (h, i).

3. Dispositif de mémoire, selon l'une quelconque des revendications 1 à 2, comprenant en outre des amplificateurs de lecture (SA) destinés à lire les informations enregistrées dans les cellules de mémoire, par l'intermédiaire des lignes de bits principales.

4. Dispositif de mémoire, selon l'une quelconque des revendications précédentes, comprenant en outre :
un substrat sur lequel la pluralité des blocs de mémoire est définie ; et
une pluralité de couches conductrices qui est formée dans le substrat, s'étendant dans le sens d'une colonne vers des blocs adjacents, pour être utilisée en tant que sous-lignes de bits (SB).

5. Dispositif de mémoire, selon la revendication 4, dans lequel les lignes de sélection de blocs sont agencées dans le sens d'une rangée et sont formées au-dessus des couches conductrices selon un schéma d'entrecoupement, les lignes de sélection de blocs étant connectées pour contrôler les bornes des transistors de sélection de blocs (STO ; SGT ; STE) formées dans la section de sélection de blocs ; et
une pluralité de lignes de bits principales conductrices (MBL) qui est formée au-dessus des lignes de sélection de blocs.

6. Dispositif de mémoire, selon la revendication 5, comprenant en outre :
une pluralité de deuxièmes lignes de sélection de blocs conductrices (BLO) qui est agencée dans le sens d'une rangée et qui est formée au-dessus des couches conductrices dans un schéma d'entrecoupement, les deuxièmes lignes de sélection de blocs étant connectées à des deuxièmes transistors de sélection de blocs (STO) formés dans une deuxième section de sélection (SSBhi) partagée par des blocs adjacents (h, i) ; et
une pluralité de lignes de bits principales conductrices (MBL) qui est formée au-dessus des deuxièmes lignes de sélection de blocs et pouvant être connectée de façon sélective à un deuxième sous-ensemble de sous-lignes de bits par l'intermédiaire des deuxièmes transistors de sélection de blocs.

7. Dispositif de mémoire, selon l'une quelconque des revendications précédentes, dans lequel les transistors de sélection de blocs (SGT ; STE) et/ou les deuxièmes transistors de sélection de blocs (STO) sont formés dans une zone conductrice et sont définis par des zones d'oxyde épais.

8. Dispositif de mémoire, selon l'une quelconque des revendications 4 à 5, dans lequel l'une des couches conductrices est déconnectée électriquement d'une autre couche conductrice par une zone de blocage de canal (17 ; 22).

9. Dispositif de mémoire, selon l'une quelconque des revendications 1 à 8, dans lequel un transistor de sélection-de blocs est agencé en série avec un transistor à déplétion qui lui est associé, lequel est conducteur pendant une opération de lecture.

10. Procédé servant à lire une cellule de mémoire sélectionnée (M41) dans un bloc de mémoire (i) d'un dispositif de mémoire, le bloc de mémoire étant situé entre un premier et un deuxième blocs adjacents (h, j), le procédé comprenant les étapes consistant à :
activer un premier dispositif de commutation (SGTij ; STE2ij) afin de connecter une première ligne de bits principale (MBL2) à une première sous-ligne de bits (SB4) laquelle est adjacente à la cellule de mémoire sélectionnée ; et
activer un deuxième dispositif de commutation (SBT3i ; ST03hi) afin de connecter une deuxième ligne de bits principale (MBL3) à une deuxième sous-ligne de bits (SB5) laquelle est adjacente à la cellule de mémoire sélectionnée ; dans lequel
la connexion de l'une au moins de la première sous-ligne de bits ou de la deuxième sous-ligne de bits provoque la connexion d'une sous-ligne de bits correspondante (SB4j ; SB5h) dans l'un des blocs adjacents, soit le premier soit le deuxième, avec la ligne de bits principale (MBL2 ; MBL3) ;
la connexion de l'une au moins de la première sous-ligne de bits ou de la deuxième sous-ligne de bits est effectuée par le biais d'un transistor de sélection de blocs (STO ; STE ; SGT) ayant une largeur de canal qui est déterminée par une largeur d'une ligne de sélection de blocs correspondante (SGL ; BLE ; BLO) ; **caractérisé en ce qu'**une zone de blocage de canal (17 ; 22) est intercalée sous chaque ligne de sélection de blocs afin d'empêcher toute connexion indésirable.
